# EUROPÄISCHE PATENTSCHRIFT

(11) **EP 3 257 701 B1**
(45) Veröffentlichungstag und Bekanntmachung des Hinweises auf die Patenterteilung: **13.09.2023**
(21) Anmeldenummer: 17020204.8
(22) Anmeldetag: 10.05.2017
(51) Int. Cl.: H02J 7/00, B60L 53/16, B60L 53/18, B60L 53/302, B60L 53/31

(54) **LADEVORRICHTUNG FÜR EINEN ENERGIESPEICHER EINES ELEKTRISCHEN FAHRZEUGS**
LOADING DEVICE FOR AN ENERGY STORAGE DEVICE OF AN ELECTRIC VEHICLE
PROCÉDÉ DE CHARGEMENT D'UN ACCUMULATEUR D'ÉNERGIE POUR UN VÉHICULE ÉLECTRIQUE

(30) Priorität: 15.06.2016 DE 102016110937
(43) Veröffentlichungstag der Anmeldung: 20.12.2017
(73) Patentinhaber: Dr. Ing. h.c. F. Porsche AG, 70435 Stuttgart (DE)
(72) Erfinder: Koehler, David, 74321 Bietigheim-Bissingen (DE); Reber, Volker, 74544 Michelbach an der Bilz (DE)

(56) Entgegenhaltungen:
- EP-A2- 0 751 536
- WO-A2-2010/049775
- DE-A1-102010 007 975
- DE-A1-102011 109 414
- DE-A1-102015 101 140
- DE-B3-102010 050 562
- JP-A- 2012 147 642
- US-A1- 2012 043 935
- US-A1- 2014 007 594
- US-A1- 2015 217 654

## Beschreibung

Die Erfindung betrifft eine Ladevorrichtung für einen Energiespeicher eines elektrisch angetriebenen Fahrzeugs gemäß dem Oberbegriff des Patentanspruchs 1 und ein Verfahren zum Kühlen eines Ladesteckers mit der Ladevorrichtung.

In der Druckschrift DE 10 2015 101 140 A1 wird eine Ladestation gemäß dem Oberbegriff des Patentanspruchs 1 beschrieben. Diese bekannte Ladestation weist einen Ladestecker zur Kopplung mit einem Energieempfänger auf, wobei der Ladestecker in einer in der Ladestation angeordneten Halteeinrichtung zum Halten des Ladesteckers positioniert werden kann (Parkposition). Die Ladestation umfasst ferner einer Kühleinrichtung, mittels der der in der Parkposition befindliche Ladestecker kühlbar ist. Das limitierende Kriterium beim Laden, insbesondere Schnelladen, eines Energiespeichers eines elektrisch angetriebenen Fahrzeugs ist die Kontakttemperatur zwischen dem Ladestecker der Ladevorrichtung und dem Fahrzeuganschluss. Durch den Spannungsabfall der Steckverbindung heizt sich die Steckverbindung zwischen. Ladestecker und dem Fahrzeuganschluss um ein entsprechendes Temperaturdelta auf. Um hohe Leistungen beim Laden von Elektrofahrzeugen zu erzielen wird eine Kühlung in den Ladestecker integriert und die Kühlleitungen durch das Ladekabel geführt. Beispielsweise wird in der DE 10 2010 050 562 B3 eine Vorrichtung zum Laden eines elektrischen Fahrzeugs beschrieben, bei dem ein mit dem aufzuladenden Fahrzeug verbindbaren Stecker mit einem Kühlkreislauf verbunden ist zum Kühlen wenigstens eines Teils des Steckers. Eine ähnliche Vorrichtung wird auch in der US 2015/217654 A1 beschrieben. Der in US 2015/217654 A1 offenbarte Kühlkreislauf ist innerhalb des Kabels angeordnet und das Kühlmittel kann hierbei an einem Ende des Kabels, über einen U-förmigen Kühlkanal, zurückgeleitet werden.

Ferner offenbart WO 2010/049775 A2 ein Ladekabel für ein elektrisches Fahrzeug, wobei dieses lösbar eine Verbindung zwischen einer Steckdose und dem Fahrzeug herstellen kann. Eine Temperaturmesseinheit kann hierbei die Temperatur des Steckers messen. Weiterhin umfasst die Vorrichtung eine Schalteinheit, welche gewisse Strompfade Öffnen und Schließen kann zwischen dem Netzstecker und dem Kabelverbinder.

Es besteht daher das ständige Bedürfnis, den Steckeräufbau und die Ladeleitung einer Ladevorrichtung für einen Energiespeicher eines elektrisch angetriebenen Fahrzeugs zu vereinfachen.

Aufgabe der vorliegenden Erfindung ist es, Maßnahmen für eine Ladevorrichtung für einen Energiespeicher eines elektrisch angetriebenen Fahrzeugs aufzuzeigen, welche die Ladevorrichtung vereinfachen.

Die Lösung der Aufgabe erfolgt erfindungsgemäß durch eine Ladevorrichtung mit den Merkmalen des Anspruchs 1, sowie ein Verfahren mit den Merkmalen des Anspruchs 3. Bevorzugte Ausgestaltungen der Erfindung sind in den Unteransprüchen und der nachfolgenden Beschreibung angegeben, die jeweils einzeln oder in Kombination einen Aspekt der Erfindung darstellen können.

Die Erfindung betrifft eine Ladevorrichtung für einen Energiespeicher eines elektrisch angetriebenen Fahrzeugs, umfassend einen Ladestecker zur Übertragung einer elektrischen Ladung an den Energiespeicher des Kraftfahrzeugs, eine Ladeleitung zur Verbindung des Ladesteckers mit einem Stromnetz, und eine Ladesäule mit einer Dockingstation zur Aufnahme des Ladesteckers bei Nichtbenutzung und zur Verbindung der Ladeleitung mit dem Stromnetz, wobei in der Dockingstation eine Kühlvorrichtung zur Kühlung des Ladesteckers angeordnet ist.

Dabei kann die Ladevorrichtung eine Ladestation für ein elektrisch angetriebenes Fahrzeug sein. Der Energiespeicher kann eine Batterie, insbesondere eine Traktionsbatterie sein. Durch eine Anordnung der Kühlvorrichtung in die Ladesäule kann der Ladestecker während einer Ruhephase vor dem Aufladen eines Fahrzeugs in der Dockingstation auf eine vorgegebene Temperatur gekühlt oder auf eine vorgegebene Temperatur gehalten werden. Auf diese Weise kann der Ladestecker auf eine vorgegebene gewünschte niedrige Temperatur, beispielsweise kleiner oder gleich 10°C, vorkonditioniert werden. Somit kann ein vorgekühlter Ladestecker zum Laden eines Kraftfahrzeugs verwendet werden. Nach Abschluss des Ladevorgangs kann der Stecker wieder in die Dockingstation gesteckt werden, um abgekühlt zu werden. Dabei kann die Kühlvorrichtung derart ausgestaltet und/oder gewählt werden, dass es der Frequentierung der Ladevorrichtung entspricht. Der Zeitraum zwischen dem Wegfahren und dem Heranfahren des darauffolgenden Fahrzeugs kann zum Kühlen des Ladesteckers genutzt werden und sollte ausreichen um den Ladestecker auf eine vorgegebene gewünschte Temperatur zu kühlen. Sollte beispielsweise bei hohen Umgebungstemperaturen der Ladevorgang wegen Überhitzung des Ladesteckers abgebrochen werden, kann der Ladestecker kurzzeitig in der Dockingstation abgekühlt werden.

Weiterhin ermöglicht ein derartiger Aufbau eine leichtere Ladeleitung aufgrund fehlender Kühlschläuche in der Ladeleitung. Insbesondere kann die Komplexität im Aufbau des Ladesteckers reduziert werden, da die Kühlvorrichtung in der Ladesäule integriert ist. Die Dockingstation kann aufgrund des größeren Bauraums in der Ladesäule frei gestaltet werden.

Auf diese Weise kann eine Ladevorrichtung für einen Energiespeicher eines elektrisch angetriebenen Fahrzeugs vereinfacht ausgestaltet werden.

Es ist erfindungsgemäß vorgesehen, dass die Kühlvorrichtung eine Luftkühlvorrichtung aufweist. Mit Hilfe einer Luftkühlvorrichtung kann eine Oberfläche von wärmeerzeugenden Objekten durch daran vorbeiströmender Luft gekühlt werden. Die zur Luftkühlung notwendige Luftbewegung kann entweder durch Konvektion oder durch einen Ventilator erfolgen. Dabei kann der Ladestecker auch Kühlrippen und/oder einen Kühlkörper als Wärmeübertrager aufweisen um durch eine größere Oberfläche einen größere Wärmeabgabe zu ermöglichen.

Alternativ weist die Kühlvorrichtung eine Flüssigkeitskühlvorrichtung auf. Mit Hilfe einer Flüssigkeitskühlvorrichtung kann ein wärmeerzeugendes Gerät mit Hilfe einer Flüssigkeit gekühlt werden. Dies hat gegenüber einer Luftkühlung den Vorteil, dass größere Wärmemengen abgeführt werden können. Als Kühlflüssigkeit kann beispielsweise Wasser oder Öl verwendet werden. Beispielsweise kann eine Flüssigkeitsvorrichtung derart ausgestaltet sein, dass eine Kühlflüssigkeit die Dockingstation umströmt. Die Innenwand einer Aufnahme der Dockingstation kontaktiert den Ladestecker und kann auf diese Weise Wärme von dem Ladestecker an die Kühlflüssigkeit übertragen.

Ferner weist die Kühlvorrichtung erfindungsgemäß eine elektrische Kühlvorrichtung auf, insbesondere ein Peltierelement auf. Eine elektrische Kühlvorrichtung ist ein elektrothermischer Wandler, welcher basierend auf dem Peltier-Effekt bei Stromdurchfluss eine Temperaturdifferenz erzeugen kann.

Die Erfindung betrifft weiterhin ein Verfahren zum Kühlen eines Ladesteckers mit einer Ladevorrichtung, welche wie vorstehend ausgebildet oder weitergebildet sein kann, umfassend die Schritte: Einstecken des Ladesteckers in die Dockingstation, und Abkühlen des Ladesteckers auf eine vorgegebene Temperatur in der Dockingstation.

Durch diese Verfahren kann ein Ladestecker auf einfache Weise abgekühlt werden. Insbesondere kann ein derartiges Verfahren eine Vereinfachung einer Ladevorrichtung ermöglichen, da die Kühlvorrichtung anstatt aufwendig in einem Ladestecker und in einer Ladeleitung einfach in die Ladesäule integriert werden kann. Durch das Verfahren kann der Ladestecker vor dem Aufladen in der Dockingstation auf eine vorgegebene gewünschte Temperatur vorkonditioniert werden.

Auf diese Weise kann durch das Verfahren eine Ladevorrichtung für einen Energiespeicher eines elektrisch angetriebenen Fahrzeugs vereinfacht werden.

Es ist bevorzugt, dass der Ladestecker durch die Dockingstation zwischen einem Wegfahren eines Fahrzeugs und einem Heranfahren eines darauffolgenden Fahrzeugs bis auf eine vorgegebene Temperatur abgekühlt und auf der vorgebebenen Temperatur gehalten wird. Auf diese Weise kann der Ladestecker sofort zum Aufladen eines darauffolgenden Fahrzeugs verwendet werden. Es kann somit Wartezeit für das Abkühlen Vorzugsweise wird bei einem Abbruch eines Ladevorgangs wegen Überhitzens des Ladesteckers der Ladestecker in Dockingstation zur Kühlung eingesteckt. Auf diese Weise kann Ladestecker durch die Dockingstation schnell auf eine vorgebebene Temperatur gekühlt werden. Insbesondere kann durch das Verfahren die Ladevorrichtung auch in Umgebungen eingesetzt werden, welche eine hohe Umgebungstemperatur aufweisen.

In einer bevorzugten Ausführungsform ist die vorgegebene Temperatur kleiner oder gleich 10°C ist. Eine derartige vorgegebene Temperatur ermöglicht es, dass der Ladestecker während des Ladevorgangs und der dadurch entstehenden Kontakttemperatur nicht überhitzt, so dass ein fehlerfreies und unterbrechungsfreies Aufladen des Fahrzeugs ermöglicht werden kann.

Es ist erfindungsgemäß vorgesehen, dass die Dockingstation die Temperatur des Ladesteckers vor dem Abkühlen ermittelt. Auf diese Weise kann die Kühlvorrichtung entsprechend der Temperatur des Ladesteckers eingestellt werden, so dass je nach Bedarf durch die Kühlvorrichtung mehr oder weniger Energie zum Kühlen benötigt wird. Insbesondere ist erfindungsgemäß vorgesehen, dass die Dockingstation die Temperatur des Ladesteckers während des Ladevorgangs ermittelt so dass die Kühlvorrichtung bereits beim Einstecken des Ladesteckers in die Dockingstation entsprechend eingestellt wird, um den Ladestecker auf eine vorgegebene Temperatur zu kühlen.

Vorzugsweise wird der Ladestecker für einen Schnellladevorgang verwendet. Durch das Schnellladen kann ein Energiespeicher eines Fahrzeugs innerhalb kürzester Zeit aufgeladen werden, so dass lange Wartezeiten für den Fahrzeugbenutzer vermieden werden können.

Nachfolgend wird die Erfindung unter Bezugnahme auf die anliegenden Zeichnungen anhand bevorzugter Ausführungsbeispiele exemplarisch erläutert, wobei die nachfolgend dargestellten Merkmale sowohl jeweils einzeln als auch in Kombination einen Aspekt der Erfindung darstellen können. Es zeigen:
Fig. 1: eine schematische Zeichnung einer Ladevorrichtung und
Fig. 2: einen Kurvenverlauf der Temperatur des Ladesteckers beim Aufladen eines Energiespeichers und beim Abkühlen in der Dockingstation.

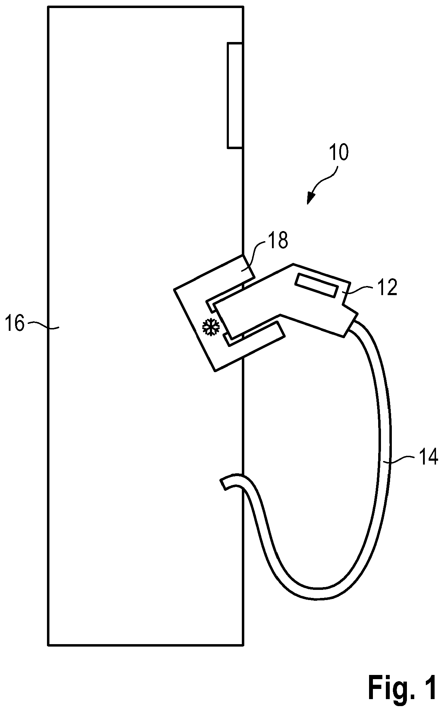

In Fig. 1 ist eine Ladevorrichtung 10 zum Aufladen eines Energiespeichers, beispielsweise eine Traktiönsbatterie, eines nicht dargestellten Kraftfahrzeugs dargestellt. Dabei wird die Ladevorrichtung 10 insbesondere zum Schnelladen des Energiespeichers verwendet. Die Ladevorrichtung 10 umfasst einen Ladestecker 12 zur Übertragung einer elektrischen Ladung an den Energiespeicher des Kraftfahrzeugs, eine Ladeleitung 14 zur Verbindung des Ladesteckers 12 mit einem Stromnetz, und eine Ladesäule 16 mit einer Dockingstation 18 zur Aufnahme des Ladesteckers 12 bei Nichtbenutzung und zur Verbindung der Ladeleitung 14 mit dem Stromnetz. Es ist erkennbar, dass in Fig. 1 der Ladestecker 12 in der Dockingstation 18 aufgenommen ist. Die Ladeleitung 14 wird innerhalb der Ladesäule mit dem Stromnetz verbunden. Die Dockingstation 18 umfasst eine Kühlvorrichtung zur Kühlung des Ladesteckers 12. Die Kühlvorrichtung ist symbolisch mit einem Stern in der Dockingstation 18 dargestellt. Die Kühlung kann beispielsweise eine Luftkühlvorrichtung in Form eines Ventilators, eine Flüssigkeitskühlvorrichtung und/oder ein Peltierelement sein. Dabei kann die Dockingstation 18 die Temperatur des Ladesteckers 12 ermitteln und den Ladestecker 12 bei Bedarf auf eine vorgegebene Temperatur von beispielsweise 10°C abkühlen oder auf die vorgegebene Temperatur von beispielsweise 10°C halten.

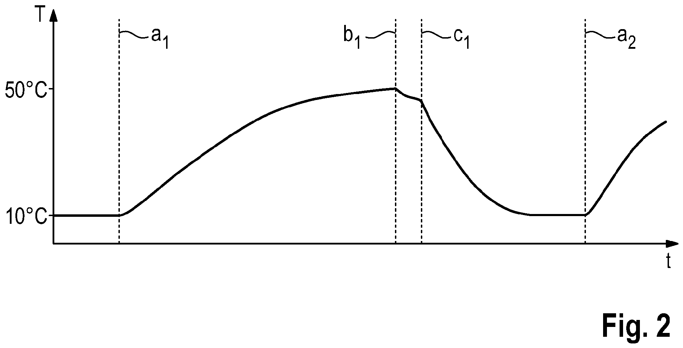

Fig. 2 stellt einen Temperaturverlauf des Ladesteckers 12 der Ladevorrichtung 10 der Fig. 1 dar. Auf der x-Achse ist die Zeit t eingetragen und auf der y-Achse die Temperatur T. Bis zum Zeitpunkt a1 wird der Ladestecker 12 durch die Dockingstation 18 auf eine Temperatur von 10°C gehalten. Am Zeitpunkt a1 wird der Ladestecker 12 mit einem Fahrzeug verbunden um einen Energiespeicher des Fahrzeugs, beispielsweise eine Traktionsbatterie, in einem Schnelladeverfahren aufzuladen. Dabei steigt die Temperatur im Ladestecker 12 über die Zeit t bis zum Zeitpunkt b1 auf 50°C an. Am Zeitpunkt b1 ist der Ladevorgang am Fahrzeug beendet oder der Ladestecker 12 ist überhitzt, so dass der Ladevorgang abgebrochen werden muss. Am Zeitpunkt c1 ist der Ladestecker 12 in der Dockingstation 18 eingesteckt. Zwischen dem Zeitpunkt b1 und dem Zeitpunkt c1 wird der Ladestecker 12 bereits durch die Umgebungsluft beim Abkoppeln des Ladesteckers 12 vom Fahrzeug bis zum Einstecken i die Dockingstation 18 abgekühlt. Die Dockingstation 18 ermittelt während des Ladevorgangs die Temperatur des Ladesteckers 12 und die Kühlvorrichtung der Dockingstation 18 wird entsprechend der Temperatur des Ladesteckers 12 betrieben, um schnellstmöglich den Ladestecker auf 10°C abzukühlen. Zwischen dem Zeitpunkt c1 und dem Zeitpunkt a2 fährt das aufgeladene Fahrzeug weg und ein darauffolgendes Fahrzeug fährt heran. In dieser Zeitspanne wird der Ladestecker 12 auf 10°C abgekühlt. Ab dem Zeitpunkt a2 wird das herangefahrene Fahrzeug aufgeladen.

## Patentansprüche

1. Ladevorrichtung für einen Energiespeicher eines elektrisch angetriebenen Fahrzeugs, umfassend:
einen Ladestecker (12) zur Übertragung einer elektrischen Ladung an den Energiespeicher des Kraftfahrzeugs,
eine Ladeleitung (14) zur Verbindung des Ladesteckers (12) mit einem Stromnetz, und
eine Ladesäule (16) mit einer Dockingstation (18) zur Aufnahme des Ladesteckers (12) bei Nichtbenutzung und zur Verbindung der Ladeleitung (14) mit dem Stromnetz,
wobei in der Dockingstation (18) eine Kühlvorrichtung zur Kühlung des Ladesteckers (12) angeordnet ist, wobei die Kühlvorrichtung eine Luftkühlvorrichtung oder eine Flüssigkeitskühlvorrichtung aufweist, **dadurch gekennzeichnet, dass** die Kühlvorrichtung ferner eine elektrische Kühlvorrichtung aufweist, wobei die Dockingstation (18) dazu eingerichtet ist, die Temperatur des-Ladesteckers (12) während eines Ladevorgangs zu ermitteln, so dass die Kühlvorrichtung bereits beim Einstecken des Ladesteckers (12) in die Dockingstation (18) entsprechend einstellbar ist um den Ladestecker auf eine vorgegebene Temperatur zu kühlen.

2. Ladevorrichtung nach Anspruch 1, **dadurch gekennzeichnet, dass** die elektrische Kühlvorrichtung ein Peltierelement ist.

3. Verfahren zum Kühlen eines Ladesteckers mit einer Ladevorrichtung nach einem der Ansprüche 1 oder 2, umfassend die Schritte:
Einstecken des Ladesteckers (12) in die Dockingstation (18), und Abkühlen des Ladesteckers (12) auf eine vorgegebene Temperatur in der Dockingstation,
wobei die Dockingstation (18) die Temperatur des Ladesteckers (12) während eines Ladevorgangs ermittelt, so dass die Kühlvorrichtung bereits beim Einstecken des Ladesteckers (12) in die Dockingstation (18) entsprechend eingestellt wird.

4. Verfahren nach Anspruch 3, **dadurch gekennzeichnet, dass** der Ladestecker (12) durch die Dockingstation (18) zwischen einem Wegfahren eines Fahrzeugs und einem Heranfahren eines darauffolgenden Fahrzeugs bis auf eine . vorgegebene Temperatur abgekühlt und auf der vorgebebenen Temperatur gehalten wird.

5. Verfahren nach einem der Ansprüche 3 oder 4, **dadurch gekennzeichnet, dass** bei einem Abbruch eines Ladevorgangs wegen Überhitzens des Ladesteckers (12) der Ladestecker (12) in die Dockingstation (18) zur Kühlung eingesteckt wird.

6. Verfahren nach einem der Ansprüche 3 bis 5, **dadurch gekennzeichnet, dass** die vorgegebene Temperatur kleiner oder gleich 10°C ist.

7. Verfahren nach einem der Ansprüche 3 bis 6, **dadurch gekennzeichnet, dass** der Ladestecker (12) für einen Schnellladevorgang des Energiespeichers des elektrisch angetriebenen Fahrzeugs verwendet wird.

## Claims

1. A charging apparatus for an energy storage device of an electrically driven vehicle, comprising:
a charging plug (12) for transmitting an electrical charge to the energy storage device of the motor vehicle,
a charging line (14) for connecting the charging plug (12) to a power grid, and
a charging column (16) with a docking station (18) for receiving the charging plug (12) when not in use and for connecting the charging line (14) to the power grid,
wherein a cooling apparatus for cooling the charging plug (12) is arranged in the docking station (18), wherein the cooling apparatus comprises an air-cooling apparatus or a liquid-cooling apparatus, **characterised in that** the cooling apparatus further comprises an electrical cooling apparatus, wherein the docking station (18) is configured so as to determine the temperature of the charging plug (12) during a charging operation, so that the cooling apparatus is accordingly adjustable when the charging plug (12) is inserted into the docking station (18) in order to cool the charging plug to a specified temperature.

2. The charging apparatus according to claim 1, **characterised in that** the electrical cooling apparatus is a Peltier element.

3. A method for cooling a charging plug with a charging apparatus according to any one of claims 1 or 2, comprising the following steps:
inserting the charging plug (12) into the docking station (18), and cooling the charging plug (12) to a specified temperature in the docking station,
wherein the docking station (18) determines the temperature of the charging plug (12) during a charging operation, so that the cooling apparatus is adjusted accordingly already upon insertion of the charging plug (12) into the docking station (18).

4. The method according to claim 3, **characterised in that** the charging plug (12) is cooled by the docking station (18) to a specified temperature and maintained at the specified temperature between a departure of a vehicle and an approach of a subsequent vehicle.

5. The method according to any one of claims 3 or 4, **characterised in that**, upon cancellation of a charging operation due to overheating of the charging plug (12), the charging plug (12) is inserted into the docking station (18) for cooling.

6. The method according to any one of claims 3 to 5, **characterised in that** the specified temperature is less than or equal to 10°C.

7. The method according to any one of claims 3 to 6, **characterised in that** the charging plug (12) is used for a rapid charging operation of the energy storage device of the electrically driven vehicle.

## Revendications

1. Dispositif de recharge d'un accumulateur d'énergie de véhicule électrique, comprenant :
une fiche de recharge (12) destinée à transmettre une charge électrique à l'accumulateur d'énergie du véhicule automobile,
un câble de recharge (14) destiné à relier la fiche de recharge (12) à un réseau électrique, et
une borne de recharge (16) dotée d'un socle de prise (18) destiné à recevoir la fiche de recharge (12) lorsqu'elle n'est pas en utilisation et à relier le câble de recharge (14) au réseau électrique ;
un dispositif de refroidissement destiné à refroidir la fiche (12) étant disposé dans le socle de prise (18), ledit dispositif de refroidissement présentant un dispositif de refroidissement à l'air ou un dispositif de refroidissement à liquide ; **caractérisé en ce que** le dispositif de refroidissement présente en outre- un dispositif de refroidissement électrique, ledit socle de prise (18) étant conçu pour déterminer la température de la fiche de recharge (12) pendant une recharge, de telle façon que le dispositif de refroidissement peut se trouver au réglage adéquat dès que la fiche de recharge (12) est replacée dans le socle de prise (18) pour pouvoir refroidir la fiche de recharge à une température prédéfinie.

2. Dispositif de recharge selon la revendication 1, **caractérisé en ce que** le dispositif de refroidissement électrique est un élément Peltier.

3. Procédé de refroidissement d'une fiche de recharge avec un dispositif de charge selon l'une quelconque des revendications 1 et 2, comprenant les étapes consistant à :
brancher la fiche de recharge (12) dans le socle de prise (18), et refroidir la fiche de recharge (12) à une température prédéfinie dans le socle de prise ;
ledit socle de prise (18) déterminant la température de la fiche de recharge (12) pendant la recharge, de telle façon que le dispositif de refroidissement se trouve au réglage adéquat dès que la fiche de recharge (12) est replacée dans le socle de prise (18).

4. Procédé selon la revendication 3, **caractérisé en ce que** la fiche de recharge (12) est refroidie par le socle de prise (18) entre le départ d'un véhicule et l'arrivée du véhicule suivant pour atteindre une température prédéfinie et est maintenue à cette température prédéfinie.

5. Procédé selon l'une des revendications 3 et 4, **caractérisé en ce que**, en cas d'interruption d'une recharge en raison d'une surchauffe de la fiche de recharge (12), la fiche de recharge (12) est replacée dans le socle de prise (18).

6. Procédé selon l'une des revendications 3 à 5, **caractérisé en ce que** la température prédéfinie est inférieure ou égale à 10 °C.

7. Procédé selon l'une des revendications 3 à 6, **caractérisé en ce que** la fiche de recharge (12) sert à une recharge rapide de l'accumulateur d'énergie du véhicule électrique.
